# EUROPEAN PATENT APPLICATION

(11) **EP 4 744 815 A1**
(43) Date of publication of application: **20.05.2026**
(21) Application number: 24875874.0
(22) Date of filing: 09.01.2024
(51) Int. Cl.: B23K 26/21, B23K 26/70

(54) **POLE COORDINATE DETERMINATION METHOD, WELDING METHOD, AND WELDING SYSTEM**

(30) Priority: 08.10.2023 CN 202311289679
(71) Applicant: Contemporary Amperex Technology Co., Limited, Ningde, Fujian 352100 (CN)
(72) Inventor: ZHAO, Jun, Ningde, Fujian 352100 (CN); XIE, Wenjie, Ningde, Fujian 352100 (CN); WU, Ying, Ningde, Fujian 352100 (CN); WANG, Wenchong, Ningde, Fujian 352100 (CN); JING, Zhiyong, Ningde, Fujian 352100 (CN); GONG, Xueqing, Ningde, Fujian 352100 (CN)
(74) Representative: Ran, Handong
(86) International application number: PCT/CN2024/071329
(87) International publication number: WO 2025/077042

(57) **Abstract**

Embodiments of the present disclosure provide a pole coordinate determination method, a welding method, and a welding system. The pole coordinate determination method comprises: acquiring a first design drawing, in a drawing coordinate system, of a battery product of a first model to be welded; analyzing the first design drawing, and obtaining a first coordinate set, in the drawing coordinate system, of at least one pole in the battery product of the first model; and mapping the first coordinate set into an addressing station coordinate system, and obtaining a second coordinate set of the at least one pole in the addressing station coordinate system.

## Description

### CROSS-REFERENCE TO RELATED APPLICATION

The present invention is based upon and claims priority to Chinese Patent Application No. 202311289679.6 filed on October 8, 2023 and entitled "METHOD FOR DETERMINING COORDINATES OF TERMINAL POST, WELDING METHOD, AND WELDING SYSTEM", which is incorporated by reference in its entirety.

### TECHNICAL FIELD

The present invention relates to the field of battery product welding technologies, and in particular to a method for determining coordinates of a terminal post, a welding method, and a welding system.

### BACKGROUND

New energy batteries are increasingly more widely applied in life and industry. For example, new energy vehicles equipped with batteries have been widely used. In addition, batteries are increasingly applied in fields of energy storage and the like.

In a producing process of battery products, welding of terminal posts is a very important step. However, during model changeover of battery products being welded, operators are required to perform manual commissioning on coordinates of terminal posts in addressing station coordinate systems, which is time-consuming and consumes a lot of manpower.

### SUMMARY OF THE INVENTION

In view of this, embodiments of the present invention provide at least a method for determining coordinates of a terminal post, a welding method, and a welding system, which are capable of efficiently and accurately determining coordinates of a terminal post of a battery product in an addressing station coordinate system, thereby greatly reducing input of commissioning personnel, improving commissioning efficiency, and reducing a commissioning error rate, so as to be capable of improving efficiency and accuracy of pre-welding addressing and photographing, and improving production efficiency and production quality of battery products.

Technical solutions of the embodiments of the present invention are implemented as follows:
An embodiment of the present invention provides a method for determining coordinates of a terminal post, the method including:
obtaining a first design drawing of a first-model battery product to be welded in a drawing coordinate system;
parsing the first design drawing to obtain a first coordinate set of at least one terminal post in the first-model battery product in the drawing coordinate system; and
mapping the first coordinate set to an addressing station coordinate system to obtain a second coordinate set of the at least one terminal post in the addressing station coordinate system.

In the embodiment of the present invention, the first design drawing of the first-model battery product to be welded in the drawing coordinate system is obtained; the first design drawing is parsed to obtain the first coordinate set of the at least one terminal post in the first-model battery product in the drawing coordinate system; and the first coordinate set is mapped to the addressing station coordinate system to obtain the second coordinate set of the at least one terminal post in the addressing station coordinate system. In this way, the second coordinate set of the terminal post in the addressing station coordinate system is determined based on the first coordinate set of the first-model battery product to be welded in the drawing coordinate system. On the one hand, it is helpful for subsequently performing pre-welding addressing and photographing based on the second coordinate set of the terminal post in the addressing station coordinate system, which is capable of improving the efficiency and accuracy of performing pre-welding addressing and photographing in an addressing station, thereby improving the production efficiency and production quality of battery products. In the other hand, because there is no need for operators to perform manual commissioning on the coordinates of the terminal post in the addressing station coordinate system, the input of commissioning personnel is greatly reduced, and the commissioning error rate can be reduced, thereby further improving the production quality and production efficiency of battery products.

In some embodiments, the addressing station coordinate system is obtained by translating an origin of the drawing coordinate system to a preset reference point; and the mapping the first coordinate set to an addressing station coordinate system to obtain a second coordinate set of the at least one terminal post in the addressing station coordinate system includes: obtaining reference coordinates of the reference point in the drawing coordinate system; and for each terminal post, based on first coordinates of the terminal post and the reference coordinates, determining first offset coordinates of the terminal post relative to the reference point, and determining the first offset coordinates as second coordinates of the terminal post in the addressing station coordinate system.

In the above embodiment, the first offset coordinates of the terminal post in the battery product relative to the preset reference point are used as the second coordinates of the terminal post in the addressing station coordinate system. In this way, the second coordinates of the terminal post in the battery product are capable of being quickly determined, thereby improving positioning efficiency of the terminal post.

In some embodiments, the drawing coordinate system includes a first positioning axis and a second positioning axis that intersect each other, and positions of the first positioning axis and the second positioning axis in the drawing coordinate system are respectively aligned with positions of a third positioning axis and a fourth positioning axis in the addressing station in the addressing station coordinate system.

In the above embodiment, the positions of the mutually intersecting first positioning axis and second positioning axis in the drawing coordinate system are respectively aligned with the positions of the third positioning axis and the fourth positioning axis in the addressing station in the addressing station coordinate system, and therefore, it is convenient to position the battery product in the addressing station through the third positioning axis and the fourth positioning axis, so that positions of various terminal posts in the battery product relative to the reference point in the addressing station coordinate system are aligned with positions of various terminal posts in the first design drawing of the battery product relative to the reference point in the drawing coordinate system, thereby improving positioning efficiency of the terminal post.

In some embodiments, the reference point includes a preset terminal post in a preset-model battery product; and the obtaining reference coordinates of the reference point in the drawing coordinate system includes: obtaining a second design drawing of the preset-model battery product in the drawing coordinate system; parsing the second design drawing to obtain third coordinates of the preset terminal post in the drawing coordinate system, and using the third coordinates as the reference coordinates.

In the above embodiment, the third coordinates of the preset terminal post of the preset-model battery product in the drawing coordinate system are used as the reference coordinates, which is conducive to quickly determining the second coordinate set of at least one terminal post based on the reference coordinates for battery products of different models, thereby improving the positioning efficiency of the terminal post.

In some embodiments, the parsing the first design drawing to obtain a first coordinate set of at least one terminal post in the first-model battery product in the drawing coordinate system includes: extracting at least one primitive object from the first design drawing; for each primitive object, when the primitive object is of a circular type, determining that the primitive object represents a terminal post in the first-model battery product, and determining center coordinates of the primitive object as the first coordinates of the terminal post in the drawing coordinate system; and determining the first coordinate set based on the first coordinates of the at least one terminal post in the first-model battery product in the drawing coordinate system.

In the above embodiment, by extracting the primitive object from the design drawing, when the primitive object is of the circular type, it is determined that the primitive object represents a terminal post in the first-model battery product, and then the center coordinates of the primitive object are determined as the first coordinates of the terminal post in the drawing coordinate system. The first coordinates of the terminal post in the drawing coordinate system are capable of being quickly determined, thereby improving the positioning efficiency of the terminal post.

In some embodiments, the method further includes: sending the second coordinate set of the at least one terminal post in the addressing station coordinate system to a controller, so that the controller controls an addressing camera to perform pre-welding addressing and photographing on the terminal post in the first-model battery product based on the second coordinate set.

In the above embodiment, the controller controls the addressing camera to perform pre-welding addressing and photographing based on the second coordinate set of the terminal post in the addressing station coordinate system, which is capable of improving the efficiency of the addressing camera in addressing and photographing, and is conducive to quickly determining position information of the terminal post.

In some embodiments, the method further includes: obtaining at least one set of visual parameters, each set of visual parameters being used to perform pre-welding addressing and photographing on a terminal post in a battery product of a model; and for each model, based on a set of visual parameters corresponding to the battery product of the model, generating and storing a camera control program corresponding to the battery product of the model, the camera control program being used to control the addressing camera to perform pre-welding addressing and photographing according to the visual parameters.

In the above embodiment, a set of visual parameters corresponding to a battery product of each model is generated and stored as the camera control program corresponding to the battery product of the model. In this way, for battery products of the same model, after the first pre-welding addressing and photographing, a previously stored camera control program corresponding to the battery product of the model can be directly called to perform addressing and photographing, thereby being capable of improving the efficiency and accuracy of performing the pre-welding addressing and photographing.

In some embodiments, the method further includes: receiving a request instruction sent by the controller, the request instruction being used to request the camera control program corresponding to the first-model battery product; and sending the camera control program corresponding to the first-model battery product to the controller.

In the above embodiment, when a battery product of a certain model undergoes non-first welding model changeover, the camera control program of the battery product of the model can be quickly determined, thereby being capable of improving the efficiency and accuracy of pre-welding addressing and photographing.

An embodiment of the present invention provides a method for determining coordinates of a terminal post, the method including:
displaying a first interface by a human machine interface; obtaining, by the human machine interface, an imported first design drawing of a first-model battery product in a drawing coordinate system in response to a drawing import operation performed on the first interface; parsing, by a host computer, the first design drawing to obtain a first coordinate set of at least one terminal post in the first-model battery product in the drawing coordinate system; mapping, by the host computer, the first coordinate set to an addressing station coordinate system to obtain a second coordinate set of the at least one terminal post in the addressing station coordinate system; and displaying the second coordinate set by the human machine interface.

In the above embodiment, the drawing import operation is performed on the first interface of the human machine interface, which is capable of automatically generating the second coordinate set of the terminal post in the battery product of the corresponding model, thereby improving the efficiency of generating the second coordinate set.

An embodiment of the present invention provides a welding method, the method including:
obtaining, by a host computer, a first design drawing of a first-model battery product to be welded in a drawing coordinate system;
parsing, by the host computer, the first design drawing to obtain a first coordinate set of at least one terminal post in the first-model battery product in the drawing coordinate system;
mapping, by the host computer, the first coordinate set to an addressing station coordinate system to obtain a second coordinate set of the at least one terminal post in the addressing station coordinate system, and sending the second coordinate set to the controller and sending the second coordinate set to the controller;
receiving the second coordinate set by the controller;
controlling, by the controller, an addressing camera to perform pre-welding addressing and photographing on the at least one terminal post based on the second coordinate set, to obtain a fourth coordinate set of the at least one terminal post in the addressing station coordinate system;
mapping, by the controller, the fourth coordinate set to a welding station coordinate system to obtain a fifth coordinate set of the at least one terminal post in the welding station coordinate system; and
controlling, by the controller, a welding device to perform welding on the at least one terminal post based on the fifth coordinate set, so as to electrically connect at least two battery cells in the first-model battery product through a busbar.

In the embodiment of the present invention, the fifth coordinate set of the terminal post in the welding station coordinate system of the battery product is capable of being determined quickly and accurately, and welding is performed based on the fifth coordinate set of the terminal post in the welding station coordinate system, which is conducive to improving the efficiency and quality of welding the terminal post.

In some embodiments, the human machine interface displays the first interface; the human machine interface obtains the imported first design drawing of the first-model battery product in the drawing coordinate system in response to the drawing import operation performed on the first interface, and sends the first design drawing to the host computer; the host computer sends the second coordinate set to the human machine interface; and the human machine interface displays the second coordinate set.

In the above embodiment, by importing the drawing on the first interface and generating the second coordinate set of the terminal post in the battery product, the convenience of the operator's operation is improved, which is conducive for the operator to quickly and accurately obtain the second coordinate set.

In some embodiments, the method further includes: sending, by the controller, a request instruction to the host computer, the request instruction being used to request a camera control program corresponding to the first-model battery product; sending, by the host computer, the camera control program corresponding to the first-model battery product to the controller in response to the request instruction; and the controlling, by the controller, an addressing camera to perform pre-welding addressing and photographing on the at least one terminal post based on the second coordinate set, to obtain a fourth coordinate set of the at least one terminal post in the addressing station coordinate system includes: controlling, by the controller by calling the camera control program, the addressing camera to perform pre-welding addressing and photographing on the first-model battery product based on the second coordinate set and according to visual parameters corresponding to the first-model battery product, to obtain the fourth coordinate set.

In the above embodiment, by calling the camera control programs corresponding to battery products of different models, the operator does not need to perform manual commissioning on visual parameters of the camera for battery products of different models each time, which is conducive to improving the efficiency of determining the fourth coordinates of the terminal post in the addressing station coordinate system.

An embodiment of the present invention provides a welding system, including a host computer, a controller, an addressing device, and a welding device, the addressing device including an addressing camera.

The host computer is configured to obtain a first design drawing of a first-model battery product to be welded in a drawing coordinate system; parse the first design drawing to obtain a first coordinate set of at least one terminal post in the first-model battery product in the drawing coordinate system; map the first coordinate set to an addressing station coordinate system to obtain a second coordinate set of the at least one terminal post in the addressing station coordinate system; and send the second coordinate set to the controller.

The controller is configured to receive the second coordinate set; control the addressing camera to perform pre-welding addressing and photographing on the at least one terminal post based on the second coordinate set, to obtain a fourth coordinate set of the at least one terminal post in the addressing station coordinate system; map the fourth coordinate set to a welding station coordinate system, to obtain a fifth coordinate set of the at least one terminal post in the welding station coordinate system; and control the welding device to perform welding on the at least one terminal post based on the fifth coordinate set, so as to electrically connect at least two battery cells in the first-model battery product through a busbar.

In the welding system in the embodiment of the present invention, the first design drawing of the first-model battery product to be welded in the drawing coordinate system is obtained; the first design drawing is parsed to obtain the first coordinate set of the at least one terminal post in the first-model battery product in the drawing coordinate system; and the first coordinate set is mapped to the addressing station coordinate system to obtain the second coordinate set of the at least one terminal post in the addressing station coordinate system. In this way, the second coordinate set of the terminal post in the addressing station coordinate system is determined based on the first coordinate set of the first-model battery product to be welded in the drawing coordinate system. On the one hand, it is helpful for subsequently performing pre-welding addressing and photographing based on the second coordinate set of the terminal post in the addressing station coordinate system, which is capable of improving the efficiency and accuracy of performing pre-welding addressing and photographing in an addressing station, thereby improving the production efficiency and production quality of battery products. In the other hand, because there is no need for operators to perform manual commissioning on the coordinates of the terminal post in the addressing station coordinate system, the input of commissioning personnel is greatly reduced, and the commissioning error rate can be reduced, thereby further improving the production quality and production efficiency of battery products.

In some embodiments, the controller includes a first controller and a second controller. The first controller is configured to receive the second coordinate set; control the addressing camera to perform pre-welding addressing and photographing on the at least one terminal post based on the second coordinate set to obtain the fourth coordinate set; and send the fourth coordinate set to the second controller. The second controller is configured to map the fourth coordinate set to the welding station coordinate system to obtain the fifth coordinate set; and control the welding device to perform welding on the at least one terminal post based on the fifth coordinate set.

In the above embodiment, by mapping the fourth coordinate set of the terminal post in the addressing station coordinate system to the welding station coordinate system of the welding device in the welding station, the fifth coordinate set of each terminal post in the welding station coordinate system is obtained, and the addressing of the terminal post coordinates and the welding of the terminal post can be carried out separately and in parallel, thereby further improving the production efficiency of the battery product.

In some embodiments, the welding system further includes a human machine interface, and the human machine interface is configured to display a first interface; obtain the imported first design drawing in response to a drawing import operation performed on the first interface; receive and display the second coordinate set sent by the host computer. The host computer is further configured to obtain the first design drawing from the human machine interface; and send the second coordinate set to the human machine interface.

In the above embodiment, by importing the drawing on the first interface and generating the second coordinate set of the terminal post in the battery product, the convenience of the operator's operation is improved, which is conducive for the operator to quickly obtain the second coordinate set.

In some embodiments, the controller is further configured to send a request instruction to the host computer; receive a camera control program corresponding to the first-model battery product sent by the host computer; and control, by calling the camera control program, the addressing camera to perform pre-welding addressing and photographing on the first-model battery product based on the second coordinate set and according to visual parameters corresponding to the first-model battery product, to obtain the fourth coordinate set. The host computer is further configured to obtain at least one set of visual parameters, each set of visual parameters being used to perform pre-welding addressing and photographing on a terminal post in a battery product of a model; for each model, based on a set of visual parameters corresponding to the battery product of the model, generate and store a camera control program corresponding to the battery product of the model; and send the camera control program corresponding to the first-model battery product to the controller in response to the request instruction.

In the above embodiment, by calling the camera control programs corresponding to battery products of different models, the operator does not need to perform manual commissioning on visual parameters of the camera for battery products of different models each time, which is conducive to improving the efficiency of determining the fourth coordinates of the terminal post in the addressing station coordinate system.

It should be understood that the foregoing general descriptions and the following detailed descriptions are merely for illustration and explanation purposes and are not intended to limit the technical solutions of the present invention.

### DESCRIPTION OF DRAWINGS

The accompanying drawings herein are incorporated into the description and constitute part of the description, illustrate the embodiments conforming to the present invention, and are intended to explain the technical solutions of the present invention together with the description.
FIG. 1 is a first schematic diagram of an implementation process of a method for determining coordinates of a terminal post according to an embodiment of the present invention;
FIG. 2 is a schematic diagram of establishing a drawing coordinate system according to an embodiment of the present invention;
FIG. 3 is a schematic diagram of a third positioning axis and a fourth positioning axis in an addressing station according to an embodiment of the present invention;
FIG. 4 is a schematic diagram of an adding interface of a camera control program according to an embodiment of the present invention;
FIG. 5 is a second schematic diagram of an implementation process of a method for determining coordinates of a terminal post according to an embodiment of the present invention;
FIG. 6 is a schematic interface diagram of a first interface according to an embodiment of the present invention;
FIG. 7 is a schematic diagram of an implementation process of a welding method according to an embodiment of the present invention;
FIG. 8 is a third schematic diagram of an implementation process of a method for determining coordinates of a terminal post according to an embodiment of the present invention;
FIG. 9 is a first schematic diagram of a composition structure of a welding system according to an embodiment of the invention;
FIG. 10 is a second schematic diagram of a composition structure of a welding system according to an embodiment of the invention; and
FIG. 11 is a third schematic diagram of a composition structure of a welding system according to an embodiment of the invention.

### DETAILED DESCRIPTION

In order to make the objects, technical solutions and advantages of the present invention clearer, the technical solutions of the present invention are further elaborated in detail below in combination with the accompanying drawings and embodiments, the described embodiments should not be regarded as limitations of the present invention, and all other embodiments obtained by persons of ordinary skills in the art without making creative efforts fall within the protection scope of the present invention.

In the following description, "some embodiments" are involved, which describe a subgroup of all possible embodiments, but it is to be understood that "some embodiments" may be the same or different subsets of all possible embodiments and may be combined with each other without conflict.

The terms "first/second/third" are involved only to differentiate between similar objects and do not represent a particular ordering of objects, and it is to be understood that "first/second/third" may be interchanged in a particular order or sequence where permitted to enable the embodiments of the present invention described herein to be implemented in a particular order or sequence.

Unless otherwise defined, all technical and scientific terms used herein have the same meanings as those commonly understood by those skilled in the art to which the present invention belongs. The terms used herein are merely for the purpose of describing the present invention, but are not intended to limit the present invention.

New energy batteries are increasingly more widely applied in life and industry. New energy batteries are not only applied in energy storage power supply systems such as water power, fire power, wind power, and solar power stations, but also widely applied in electric transportation tools, such as electric bicycles, electric motorcycles and electric vehicles, as well as many fields such as aerospace. With the continuous expansion of the application field of the power batteries, the market demand is also constantly expanding.

In the embodiments of the present invention, the battery may be a battery cell (sometimes also referred to as a cell), and the battery may also be a battery module or battery pack including a plurality of battery cells. The battery cell refers to a basic unit that is capable of achieving mutual conversion between chemical energy and electric energy, and can be configured to manufacture a battery module or a battery pack, thereby supplying power to an electrical apparatus. The battery cell may be a secondary battery, and the secondary battery refers to a battery cell that can be used continually by activating an active material by means of charging after the battery cell is discharged. The battery cell may be a lithium-ion battery, a sodium-ion battery, a sodium/lithium-ion battery, a lithium-metal battery, a sodium-metal battery, a lithium-sulfur battery, a magnesium-ion battery, a nickel-metal hydride battery, a nickel-cadmium battery, a lead storage battery, and the like, which is not limited in the embodiments of the present invention.

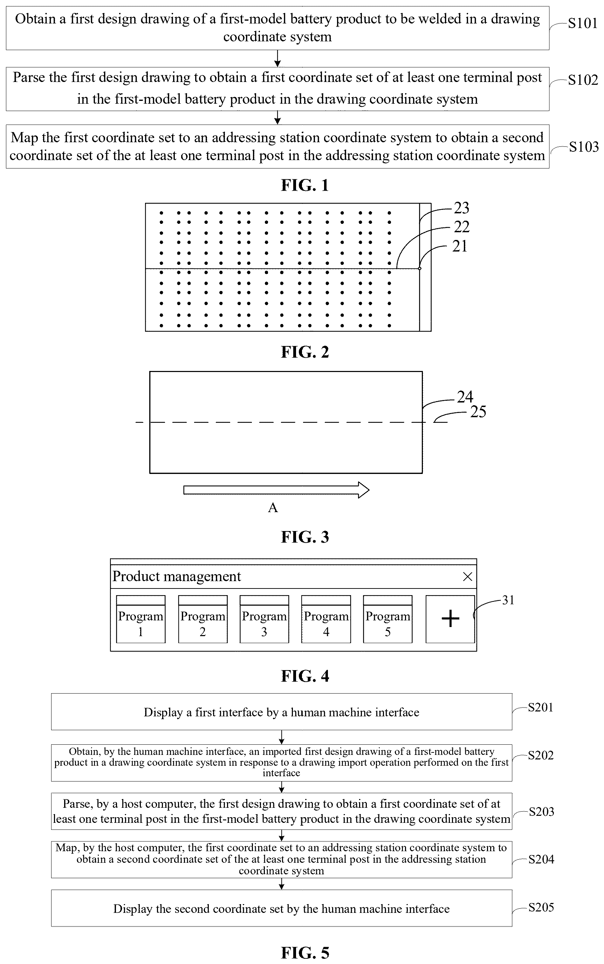

The embodiments of the present invention provide a method for determining coordinates of a terminal post, and the method may be performed by a processor of a computer device. During implementation, the computer device may be any suitable device with data processing capabilities. It is understandable that in industrial production, the computer device may refer to a host computer, such as a server, a laptop, a tablet, a desktop computer, and a smart phone, and the computer device may also refer to a slave computer, such as an industrial personal computer and a programmable logic controller (PLC). FIG. 1 is a schematic diagram of an implementation process of a method for determining coordinates of a terminal post according to an embodiment of the present invention. As shown in FIG. 1, the method may include the following step S101 to step S103.

Step S101: Obtain a first design drawing of a first-model battery product to be welded in a drawing coordinate system.

Here, the battery product may include a plurality of battery cells, and each of the battery cells may have a positive electrode terminal post and a negative electrode terminal post. For example, the battery cell may be a cell.

In some embodiments, the battery product may be a battery module composed of a plurality of battery cells. For example, the battery module may be a new-energy power battery module.

In some embodiments, the battery cell may be a battery pack composed of a plurality of battery cells or battery modules. For example, the battery pack may be a new-energy power battery pack.

In some embodiments, the drawing coordinate system refers to a coordinate system used to describe positions of various points in a design drawing of a battery product. During implementation, the coordinate system can be established by specifying an origin position and coordinate axis positions in the design drawing.

In some embodiments, the origin, the horizontal axis (denoted as X-axis) position, and the vertical axis (denoted as Y-axis) position of the drawing coordinate system may be any suitable positions and are not limited herein. For example, as shown in FIG. 2, the drawing coordinate system may take a center line 22 in a horizontal direction in the design drawing as the X-axis, a side edge 23 in a vertical direction as the Y-axis, and an intersection 21 of the X-axis and the Y-axis as the origin.

In some embodiments, before the first design drawing of the first-model battery product to be welded is obtained, a computer aided design (CAD) tool can be used to edit an initial design drawing of the first-model battery product to generate coordinate information of each terminal post in the first-model battery product, thereby generating the first design drawing.

In some embodiments, the first design drawing may include coordinate information of each terminal post in the first-model battery product in the drawing coordinate system. The first design drawing may have any suitable file format, which is not limited here. For example, the first design drawing file may be in a file format of Drawing Interchange Format (DXF) or DraWinG (DWG).

During implementation, a product model of the battery product to be welded can be obtained, and based on the product model of the battery product, the design drawing corresponding to the battery product is capable of being determined. For example, for the first-model battery product, the first design drawing corresponding to the first-model battery product may be determined by searching.

Step S102: Parse the first design drawing to obtain a first coordinate set of at least one terminal post in the first-model battery product in the drawing coordinate system.

In some embodiments, the first design drawing can be parsed using any suitable computer device, for example, at least one of a host computer, a PLC, an industrial personal computer, and the like.

In some embodiments, the first design drawing can be parsed according to the file format of the first design drawing using a parsing method corresponding to the file format, to obtain the first coordinate set of the at least one terminal post in the first-model battery product in the drawing coordinate system.

Step S103: Map the first coordinate set to an addressing station coordinate system to obtain a second coordinate set of the at least one terminal post in the addressing station coordinate system.

Here, before welding terminal posts of the battery product, at least one terminal post of the battery product to be welded may be addressed at an addressing station to obtain coordinates of various terminal posts in the addressing station coordinate system. The addressing station may be a station before a welding station, and the addressing station coordinate system may be a unified coordinate system constructed for various physical positions in the addressing station. Through the addressing station coordinate system, a visual position of the at least one terminal post of the battery product to be welded in the pre-welding addressing station can be unified into the same coordinate system. In a pre-welding addressing and photographing process, movement of an addressing camera in the addressing station and programmed positions both can use the addressing station coordinate system as a reference.

In some embodiments, any suitable mapping method may be used to map first coordinates of the terminal post in the drawing coordinate system to second coordinates of the terminal post in the addressing station coordinate system. For example, a coordinate conversion parameter between the drawing coordinate system and the addressing station coordinate system can be used to map the first coordinates of the terminal post in the drawing coordinate system to the addressing station coordinate system through translation, rotation, and/or scaling, to obtain the second coordinate set of the terminal post in the addressing station coordinate system.

In some embodiments, after the second coordinates of each terminal post in the addressing station coordinate system are obtained, the second coordinates of the terminal post can be used to perform addressing and photographing on the terminal post in the addressing station coordinate system.

In the embodiment of the present invention, the first design drawing of the first-model battery product to be welded in the drawing coordinate system is obtained; the first design drawing is parsed to obtain the first coordinate set of the at least one terminal post in the first-model battery product in the drawing coordinate system; and the first coordinate set is mapped to the addressing station coordinate system to obtain the second coordinate set of the at least one terminal post in the addressing station coordinate system. In this way, the second coordinate set of the terminal post in the addressing station coordinate system is determined based on the first coordinate set of the first-model battery product to be welded in the drawing coordinate system. On the one hand, it is helpful for subsequently performing pre-welding addressing and photographing based on the second coordinate set of the terminal post in the addressing station coordinate system, which is capable of improving the efficiency and accuracy of performing pre-welding addressing and photographing in an addressing station, thereby improving the production efficiency and production quality of battery products. In the other hand, because there is no need for operators to perform manual commissioning on the coordinates of the terminal post in the addressing station coordinate system, the input of commissioning personnel is greatly reduced, and the commissioning error rate can be reduced, thereby further improving the production quality and production efficiency of battery products.

In some embodiments, the addressing station coordinate system is obtained by translating the origin of the drawing coordinate system to a preset reference point; and the mapping the first coordinate set to an addressing station coordinate system to obtain a second coordinate set of the at least one terminal post in the addressing station coordinate system in the above step S103 may include the following steps S111 to S112.

Step S111: Obtain reference coordinates of the reference point in the drawing coordinate system.

Here, the reference point may be any suitable point in the drawing coordinate system. It is understandable that the reference point may be selected in various ways. No matter which point the reference point is determined to be, the reference point has a corresponding point in the addressing station coordinate system.

In some embodiments, the reference point may be a terminal post preset in the battery product in the drawing coordinate system of the first design drawing. For example, a terminal post at a lower left corner, a terminal post at a lower right corner, or a terminal post in a center of the battery product in the drawing coordinate system may be determined as the reference point.

Step S112: For each terminal post, based on the first coordinates of the terminal post and the reference coordinates, determine first offset coordinates of the terminal post relative to the reference point, and determine the first offset coordinates as second coordinates of the terminal post in the addressing station coordinate system.

In some implementations, for each terminal post, a coordinate difference between the first coordinates of the terminal post and the reference coordinates may be determined as the first offset coordinates of the terminal post relative to the reference point, and the first offset coordinates may be determined as the second coordinates of the terminal post in the addressing station coordinate system. During implementation, first coordinates (x, y) of a certain terminal post are obtained, first offset coordinates (x-x0, y-y0) between the first coordinates (x, y) of the terminal post relative to the reference coordinates (x0, y0) of the reference point are determined, and the first offset coordinates (x-x0, y-y0) are determined as the second coordinates of the terminal post in the addressing station coordinate system.

In some implementations, first coordinates of a certain terminal post in the drawing coordinate system are (1, 2), reference coordinates of the reference point in the drawing coordinate system are (1, 1), and a coordinate difference (0, 1) between the first coordinates and the reference coordinates of the terminal post may be determined as the second coordinates of the terminal post in the addressing station coordinate system.

In some implementations, a host computer may obtain the first coordinates of the terminal post from a DXF drawing. Based on the first coordinates of the terminal post and the reference coordinates, the host computer determines the first offset coordinates of the terminal post relative to the reference point, and determines the first offset coordinates as the second coordinates of the terminal post in the addressing station coordinate system. Afterwards, the host computer writes the second coordinates of the terminal post in the addressing station coordinate system into a PLC in the addressing station.

In the embodiment of the present invention, the first offset coordinates of the terminal post in the battery product relative to the preset reference point are used as the second coordinates of the terminal post in the addressing station coordinate system. In this way, the second coordinates of the terminal post in the battery product are capable of being quickly determined, thereby improving positioning efficiency of the terminal post.

In some embodiments, the drawing coordinate system includes a first positioning axis and a second positioning axis that intersect each other, and positions of the first positioning axis and the second positioning axis in the drawing coordinate system are respectively aligned with positions of a third positioning axis and a fourth positioning axis in the addressing station in the addressing station coordinate system.

In some embodiments, as shown in FIG. 2 and FIG. 3, a first positioning axis and a second positioning axis respectively correspond to the side edge 23 in the vertical direction and the center line 22 in the horizontal direction in the design drawing, and a third positioning axis and a fourth positioning axis in the addressing station respectively correspond to a battery product fixed positioning edge 24 on a front side of a traveling direction A of an automated guided vehicle (AGV) and an axis 25 perpendicular to and centered on the battery product fixed positioning edge. During implementation, an AGV trolley is arranged in the addressing station. The AGV trolley automatically travels along a specified route and performs battery product transportation and assembling tasks within a certain range. The AGV trolley is configured to assemble and fix the battery products. After a front side of the AGV trolley is aligned with the positioning edge, a position of the battery product may be corrected and fixed by inserting a positioning pin, so as to ensure that a position of the X-axis in the drawing coordinate system is aligned with a position of the fixed positioning edge in the addressing station coordinate system, and a position of the Y-axis in the drawing coordinate system is aligned with the axis perpendicular to and centered on the fixed positioning edge in the addressing station coordinate system.

In some implementations, the positions of the first positioning axis and the second positioning axis in the drawing coordinate system may be manually aligned with the positions of the third positioning axis and the fourth positioning axis in the addressing station in the addressing station coordinate system.

In the embodiment of the present invention, the positions of the mutually intersecting first positioning axis and second positioning axis in the drawing coordinate system are respectively aligned with the positions of the third positioning axis and the fourth positioning axis in the addressing station in the addressing station coordinate system, and therefore, it is convenient to position the battery product in the addressing station through the third positioning axis and the fourth positioning axis, so that positions of various terminal posts in the battery product relative to the reference point in the addressing station coordinate system are aligned with positions of various terminal posts in the first design drawing of the battery product relative to the reference point in the drawing coordinate system, thereby improving positioning efficiency of the terminal post.

In some embodiments, the reference point includes a preset terminal post in a preset-model battery product; and the obtaining reference coordinates of the reference point in the drawing coordinate system in the above step S111 may include the following steps S121 to S122.

Step S121: Obtain a second design drawing of the preset-model battery product in the drawing coordinate system.

Here, the preset-model battery product may be a first kind of battery product that undergoes pre-welding addressing in the addressing station, or may be a battery product of any model that has undergone the pre-welding addressing in the addressing station before performing pre-welding addressing on the first-model battery product.

During implementation, the second design drawing and the first design drawing may be in the same file format or in different file formats. For example, the second design drawing and the first design drawing are both in the DXF format. For another example, the first design drawing is a drawing in the DXF format, and the second design drawing is a drawing in the DWG format.

Step S122: Parse the second design drawing to obtain third coordinates of the preset terminal post in the drawing coordinate system, and use the third coordinates as the reference coordinates.

Here, the preset terminal post may be any suitable terminal post. For example, the preset terminal post may be a terminal post in a lower left corner, a terminal post in a lower right corner, or a center terminal post in the second design drawing of the preset-model battery product.

In an implementation, the second design drawing may be parsed to obtain third coordinates of a plurality of terminal posts in the drawing coordinate system, and the third coordinates of a terminal post may be randomly selected as the reference coordinates.

In the embodiment of the present invention, the third coordinates of the preset terminal post of the preset-model battery product in the drawing coordinate system are used as the reference coordinates, which is conducive to quickly determining the second coordinate set of the at least one terminal post based on the reference coordinates for battery products of different models, thereby improving the positioning efficiency of the terminal post.

In some embodiments, the parsing the first design drawing to obtain a first coordinate set of at least one terminal post in the first-model battery product in the drawing coordinate system in the above step S102 may include the following steps S131 to S133.

Step S131: Extract at least one primitive object from the design drawing.

In some implementations, the design drawing may be a DXF drawing, and the DXF drawing includes a plurality of primitive objects. During implementation, the plurality of primitive objects may be extracted from the DXF drawing.

Step S132: For each primitive object, when the primitive object is of a circular type, determine that the primitive object represents a terminal post in the first-model battery product, and determine center coordinates of the primitive object as the first coordinates of the terminal post in the drawing coordinate system.

During implementation, a search algorithm may be used to search among the plurality of primitive objects in the design drawing to find out a primitive object of a circular type. It is understandable that the primitive object of the circular type in the design drawing corresponds to the terminal post, and therefore, the center coordinates of the primitive object may be determined as the first coordinates of the terminal post in the drawing coordinate system.

In some implementations, when the design drawing is a DXF drawing, a search algorithm may be used to find a primitive object corresponding to a group code "CIRCLE" from an ENTITIES region in the DXF drawing, where the "CIRCLE" group code refers to a circular primitive object.

Step S133: Determine the first coordinate set based on the first coordinates of at least one terminal post in the first-model battery product in the drawing coordinate system.

In the embodiment of the present invention, by extracting the primitive object from the design drawing, when the primitive object is of the circular type, it is determined that the primitive object represents a terminal post in the first-model battery product, and then the center coordinates of the primitive object are determined as the first coordinates of the terminal post in the drawing coordinate system. The first coordinates of the terminal post in the drawing coordinate system are capable of being quickly determined, thereby improving the positioning efficiency of the terminal post.

In some embodiments, the method further includes step S141.

Step S141: Send the second coordinate set of the at least one terminal post in the addressing station coordinate system to a controller, so that the controller controls an addressing camera to perform pre-welding addressing and photographing on the terminal post in the first-model battery product based on the second coordinate set.

In some implementations, the controller here may include but is not limited to an industrial personal computer, a PLC, or the like.

In some implementations, the controller is a PLC, a host computer sends a second coordinate set of at least one terminal post in the addressing station coordinate system to the PLC, and the PLC controls the addressing camera on the addressing station based on the second coordinate set to perform pre-welding addressing and photographing; where in the process of performing addressing and photographing on each terminal post of the battery product, the addressing camera needs to move above a region where the terminal post is located to perform addressing and photographing on the terminal post.

In some implementations, an area scan camera may be used at the addressing station to perform addressing and photographing on various terminal posts to obtain the positions of the terminal posts in a corresponding addressing image, and based on the positions of the various terminal posts in the corresponding addressing image and corresponding photographing positions (that is, second coordinates corresponding to the terminal posts) when the area scan camera collects various addressing images, a fourth coordinate set of at least one terminal post in the addressing station coordinate system is determined.

In the embodiment of the present invention, the controller controls the addressing camera to perform pre-welding addressing and photographing based on the second coordinate set of the terminal post in the addressing station coordinate system, which is capable of improving the efficiency of the addressing camera in addressing and photographing, and is conducive to quickly determining position information of the terminal post.

In some embodiments, the method further includes step S151 to step S152.

Step S151: Obtain at least one set of visual parameters, each set of visual parameters being used to perform pre-welding addressing and photographing on a terminal post in a battery product of a model.

Here, the visual parameter includes at least one of an exposure value, a boundary capture logic, a grayscale value magnitude, and the like. It is understandable that adjusting the visual parameter can change a photographic effect of the pre-welding addressing and photographing of the terminal post. Since the size, reflection intensity, and the like of the terminal posts in battery products of different models vary, and in order to ensure that the terminal posts in the battery products of different models are capable of being clearly photographed, the battery products of different models each have a corresponding set of visual parameters.

In some implementations, the visual parameters corresponding to a battery product of a model may be determined through continuous commissioning by an operator, or a set of visual parameters corresponding to a battery product of a model may be obtained locally or from the cloud.

In some implementations, before using an addressing camera to perform pre-welding addressing and photographing on terminal posts in a battery product of a model to obtain an image, visual parameters of the addressing camera such as a photographing exposure value, a grayscale value magnitude, an image clarity, an image display angle, and an image field angle may be adjusted according to the visual parameters corresponding to the battery product of the model.

Step S152: For each model, based on a set of visual parameters corresponding to the battery product of the model, generate and store a camera control program corresponding to the battery product of the model, the camera control program being used to control the addressing camera to perform pre-welding addressing and photographing according to the visual parameters.

In some implementations, for a battery product of any model, a search may be performed among the plurality of kinds of stored camera control programs to determine the camera control program corresponding to the battery product of the model, and then the addressing camera may be controlled based on the camera control program corresponding to the battery product of the model to perform pre-welding addressing and photographing.

In the embodiment of the present invention, a set of visual parameters corresponding to a battery product of each model is generated and stored as the camera control program corresponding to the battery product of the model. In this way, for battery products of the same model, after the first pre-welding addressing and photographing, a previously stored camera control program corresponding to the battery product of the model can be directly called to perform addressing and photographing, thereby improving efficiency of pre-welding addressing and photographing.

In some embodiments, the method further includes step S161 to step S162.

Step S161: Receive a request instruction sent by a controller, the request instruction being used to request the camera control program corresponding to the first-model battery product.

In some implementations, after the request instruction sent by the controller is received, the camera control program corresponding to the first-model battery product is searched and determined based on the request instruction.

Step S162: Send the camera control program corresponding to the first-model battery product to the controller.

In some implementations, as shown in FIG. 4, an adding interface of the camera control program may be displayed through a human machine interface. The human machine interface may respond to a triggering operation on an add control 31 on the adding interface to display a configuration interface for visual parameters, and respond to a parameter configuration operation performed on the configuration interface to obtain a set of visual parameters corresponding to a battery product of a certain model being configured. The host computer may obtain the set of visual parameters from the human machine interface, and based on the set of visual parameters, generate and store a camera control program corresponding to the battery product of the model.

In some implementations, after the camera control program corresponding to the first-model battery product is sent to the controller, addressing and photographing may also be performed based on the camera control program corresponding to the first-model battery product.

In the embodiment of the present invention, when a battery product of a certain model undergoes non-first welding model changeover, the camera control program of the battery product of the model can be quickly determined, thereby being capable of improving the efficiency of pre-welding addressing and photographing.

The embodiments of the present invention provide a method for determining coordinates of a terminal post, and the method may be performed by a human machine interface. FIG. 5 is a schematic diagram of an implementation process of a method for determining coordinates of a terminal post according to an embodiment of the present invention. As shown in FIG. 5, the method may include the following step S201 to step S205.

Step S201: Display a first interface by the human machine interface.

Here, the human machine interface (HMI), also known as the human-machine interface, is a medium for human machine interaction and information exchange. The first interface may be displayed on any suitable electronic device with an interface interaction function. During implementation, the human machine interface may be any suitable device having a display interface, and a user may perform human machine interaction through the display interface. In some implementations, the first interface may be a partial region of the display interface.

Step S202: Obtain, by the human machine interface, an imported first design drawing of a first-model battery product in a drawing coordinate system in response to a drawing import operation performed on the first interface.

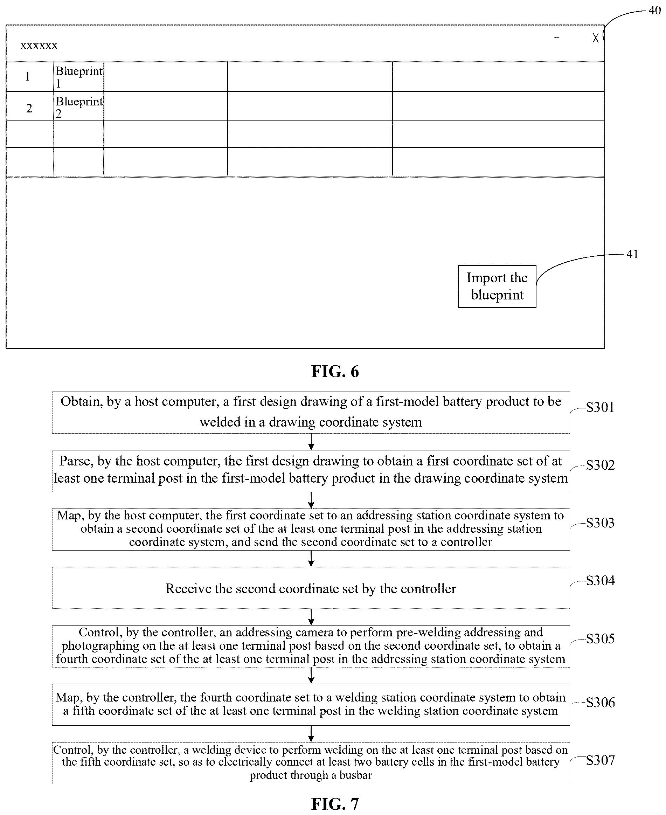

In some implementations, as shown in FIG. 6, the human machine interface may display a first interface 40, and the first interface 40 includes a drawing import control 41. By triggering the drawing import control 41, the drawing import operation may be implemented, and the first design drawing of the first-model battery product in the drawing coordinate system has been imported. Here, the first design drawing may be a blueprint for the first-model battery product.

In some implementations, the user may perform the drawing import operation on the first interface, and the human machine interface obtains the imported first design drawing of the first-model battery product in the drawing coordinate system. For example, the human machine interface may be a laptop computer, and the user uses a mouse of the laptop computer to click on the first interface on the laptop computer, selects the drawing to be imported, and imports the drawing, and the laptop computer then obtains the first design drawing of the first-model battery product imported by the user in the drawing coordinate system.

Step S203: Parse, by the host computer, the first design drawing to obtain a first coordinate set of at least one terminal post in the first-model battery product in the drawing coordinate system.

Step S204: Map, by the host computer, the first coordinate set to an addressing station coordinate system to obtain a second coordinate set of the at least one terminal post in the addressing station coordinate system.

Here, step S203 to step S204 may be implemented with reference to the aforementioned step S102 to step S103.

Step S205: Display the second coordinate set by the human machine interface.

It is understandable that the human machine interface and the host computer may be arranged independently or integrated, which is not limited in the embodiments of the present invention.

In the embodiment of the present invention, the drawing importing is performed on the first interface of the human machine interface, which is capable of automatically generating the second coordinate set of the terminal post in the battery product of the corresponding model, thereby improving the efficiency of generating the second coordinate set.

The embodiments of the present invention provide a welding method. FIG. 7 is a schematic diagram of an implementation process of a welding method according to an embodiment of the present invention. As shown in FIG. 7, the method may include the following step S301 to step S307.

Step S301: Obtain, by a host computer, a first design drawing of a first-model battery product to be welded in a drawing coordinate system.

Step S302: Parse, by the host computer, the first design drawing to obtain a first coordinate set of at least one terminal post in the first-model battery product in the drawing coordinate system.

Step S303: Map, by the host computer, the first coordinate set to an addressing station coordinate system to obtain a second coordinate set of the at least one terminal post in the addressing station coordinate system, and send the second coordinate set to the controller.

Here, step S301 to step S303 may be implemented with reference to the aforementioned step S101 to step S103.

Step S304: Receive the second coordinate set by the controller.

In some implementations, the controller may be a PLC.

In some embodiments, any suitable device may be used to obtain the second coordinate set of the at least one terminal post in the first-model battery product to be welded in the addressing station coordinate system and then send the second coordinate set to the controller. For example, the host computer may be used to obtain and send to the controller the second coordinate set of the at least one terminal post of the first-model battery product to be welded in the addressing station coordinate system.

Step S305: Control, by the controller, an addressing camera to perform pre-welding addressing and photographing on the at least one terminal post based on the second coordinate set, to obtain a fourth coordinate set of the at least one terminal post in the addressing station coordinate system.

Here, the addressing camera in the addressing station may be driven by a moving mechanism arranged on the addressing station, moved to a region above a certain terminal post where the terminal post is located to take a picture of the region, so as to obtain a photographed image. By identifying the terminal post in the image, pixel coordinates of the terminal post in the image relative to an image origin may be obtained. Based on a correspondence between a pre-calibrated number of pixels and a physical distance, fourth coordinates of the terminal post in the addressing station coordinate system may be determined. In this way, by driving the addressing camera to move to the region above each terminal post to perform addressing and photographing, the fourth coordinates corresponding to each terminal post may be obtained. In some implementations, the addressing camera on the addressing station may be an area scan camera.

Step S306: Map, by the controller, the fourth coordinate set to a welding station coordinate system to obtain a fifth coordinate set of the at least one terminal post in the welding station coordinate system.

Here, the welding station coordinate system may be a unified coordinate system constructed for various physical positions in a welding station. Through the welding coordinate system, visual positions of a plurality of terminal posts of the battery product to be welded can be unified into the same coordinate system.

During implementation, the fourth coordinate set may be mapped to the welding station coordinate system in any suitable manner, which is not limited here. For example, a preset coordinate mapping rule between the addressing station coordinate system and the welding station coordinate system may be utilized to convert the fourth coordinate set in the addressing station coordinate system into a fifth coordinate set in the welding station coordinate system through processing such as translation, rotation, and/or scaling.

Step S307: Control, by the controller, a welding device to perform welding on the at least one terminal post based on the fifth coordinate set, so as to electrically connect at least two battery cells in the first-model battery product through a busbar.

During implementation, those skilled in the art may use any appropriate welding device to perform welding on the terminal posts according to actual conditions, which is not limited in the embodiments of the present invention.

In some implementations, the welding device may include a laser welding head and a robot that drives the laser welding head to move to corresponding positions of various terminal post for performing welding.

In the embodiment of the present invention, the fifth coordinate set of the terminal post in the welding station coordinate system of the battery product is capable of being determined quickly and accurately, and welding is performed based on the fifth coordinate set of the terminal post in the welding station coordinate system, which is conducive to improving the efficiency and quality of welding the terminal post.

In some embodiments, the method further includes step S311 to step S314.

Step S311: Display a first interface by the human machine interface.

Here, step S321 may be implemented with reference to the aforementioned step S201.

Step S312: Obtain, by the human machine interface, the imported first design drawing of the first-model battery product in the drawing coordinate system in response to a drawing import operation performed on the first interface, and send the first design drawing to the host computer.

Step S313: Send, by the host computer, the second coordinate set to the human machine interface.

Step S314: Display the second coordinate set by the human machine interface.

Here, step S314 may be implemented with reference to the aforementioned step S205.

In the embodiment of the present invention, by importing the drawing on the first interface and generating the second coordinate set of the terminal post in the battery product, the convenience of the operator's operation is improved, which is conducive for the operator to quickly and accurately obtain the second coordinate set.

In some embodiments, the method further includes step S321 to step S322.

Step S321: Send, by the controller, a request instruction to the host computer, the request instruction being used to request the camera control program corresponding to the first-model battery product.

Step S322: Send, by the host computer, a camera control program corresponding to the first-model battery product to the controller in response to the request instruction.

Here, step S321 to step S322 may be implemented with reference to the aforementioned step S171 to step S172.

The controlling, by the controller, an addressing camera to perform pre-welding addressing and photographing on the at least one terminal post based on the second coordinate set, to obtain a fourth coordinate set of the at least one terminal post in the addressing station coordinate system in the above step S305 may include step S331.

Step S331: Control, by the controller by calling the camera control program, the addressing camera to perform pre-welding addressing and photographing on the first-model battery product based on the second coordinate set and according to the visual parameters corresponding to the first-model battery product, to obtain the fourth coordinate set.

In the embodiment of the present invention, by calling the camera control programs corresponding to battery products of different models, the operator does not need to perform manual commissioning on visual parameters of the camera for battery products of different models each time, which is conducive to improving the efficiency of determining the fourth coordinates of the terminal post in the addressing station coordinate system.

The following describes the application of the method for determining coordinates of a terminal post provided by the embodiments of the present invention in a practical scenario, taking a terminal post welding scenario as an example.

In a production process of a battery product, welding of terminal posts is a very important step. In related arts, during welding model changeover, persons are required to perform manual commissioning on coordinates of the terminal posts in an addressing station coordinate system. Coordinate alignment takes a long time, and the terminal post coordinate information is complex, which is prone to errors when manually input in the HMI.

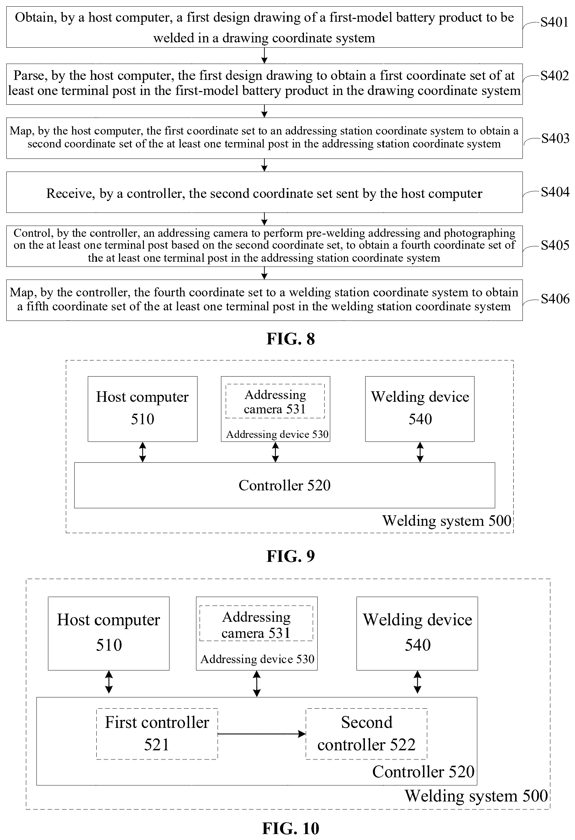

The embodiments of the present invention provide a method for determining coordinates of a terminal post. FIG. 8 is a third schematic diagram of an implementation process of a method for determining coordinates of a terminal post according to an embodiment of the present invention. As shown in FIG. 8, the method includes the following step S401 to step S406.

Step S401: Obtain, by a host computer, a first design drawing of a first-model battery product to be welded in a drawing coordinate system.

Step S402: Parse, by the host computer, the first design drawing to obtain a first coordinate set of at least one terminal post in the first-model battery product in the drawing coordinate system.

Step S403: Map, by the host computer, the first coordinate set to an addressing station coordinate system to obtain a second coordinate set of the at least one terminal post in the addressing station coordinate system.

Step S404: Receive, by the controller, the second coordinate set sent by the host computer.

Step S405: Control, by the controller, an addressing camera to perform pre-welding addressing and photographing on the at least one terminal post based on the second coordinate set, to obtain a fourth coordinate set of the at least one terminal post in the addressing station coordinate system.

Step S406: Map, by the controller, the fourth coordinate set to a welding station coordinate system to obtain a fifth coordinate set of the at least one terminal post in the welding station coordinate system.

In the production process of a battery product, the first design drawing corresponding to the battery product may be used to quickly determine the second coordinates of the terminal post in the addressing station coordinate system, without the need for a person to manually input the second coordinates of the terminal post. In addition, performing the pre-welding addressing and photographing based on the second coordinates is capable of improving the efficiency of determining the fourth coordinates of the terminal post in the addressing station coordinate system. Finally, the fourth coordinates in the addressing station coordinate system are mapped to the welding station coordinate system of the welding device in the welding station. The addressing of the terminal post coordinates and the welding of the terminal post may be carried out separately and in parallel, thereby further improving the production efficiency of the battery product.

The embodiments of the present invention provide a welding system, as shown in FIG. 9. The welding system 500 includes a host computer 510, a controller 520, an addressing device 530, and a welding device 540. The addressing device 530 includes an addressing camera 531.

The host computer 510 is configured to obtain a first design drawing of a first-model battery product to be welded in a drawing coordinate system; parse the first design drawing to obtain a first coordinate set of at least one terminal post in the first-model battery product in the drawing coordinate system; map the first coordinate set to an addressing station coordinate system to obtain a second coordinate set of the at least one terminal post in the addressing station coordinate system; and send the second coordinate set to the controller 520.

The controller 520 is configured to receive the second coordinate set; control the addressing camera 531 to perform pre-welding addressing and photographing on the at least one terminal post based on the second coordinate set, to obtain a fourth coordinate set of the at least one terminal post in the addressing station coordinate system; map the fourth coordinate set to a welding station coordinate system, to obtain a fifth coordinate set of the at least one terminal post in the welding station coordinate system; and control the welding device 540 to perform welding on the at least one terminal post based on the fifth coordinate set, so as to electrically connect at least two battery cells in the first-model battery product through a busbar.

Here, the host computer 510, the controller 520, the addressing device 530, and the welding device 540 may be communicatively connected with each other. During implementation, the host computer 510, the controller 520, the addressing device 530, and the welding device 540 may be communicatively connected via a wired network and/or a wireless network, which is not limited in the embodiment of the present invention.

In some embodiments, as shown in FIG. 10, the controller 520 includes a first controller 521 and a second controller 522.

The first controller 521 is configured to receive the second coordinate set; control the addressing camera 531 to perform pre-welding addressing and photographing on the at least one terminal post based on the second coordinate set to obtain the fourth coordinate set; and send the fourth coordinate set to the second controller 522.

The second controller 522 is configured to map the fourth coordinate set to the welding station coordinate system to obtain the fifth coordinate set; and control the welding device 540 to perform welding on the at least one terminal post based on the fifth coordinate set.

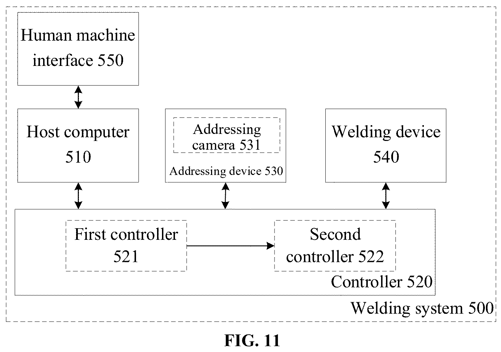

In some embodiments, as shown in FIG. 11, the welding system 500 further includes a human machine interface 550.

The human machine interface 550 is configured to display a first interface; obtain the imported first design drawing in response to the drawing import operation performed on the first interface; receive and display the second coordinate set sent by the host computer 510. The host computer 510 is further configured to obtain the first design drawing from the human machine interface 550; and send the second coordinate set to the human machine interface 550.

In some embodiments, the controller 520 is further configured to send a request instruction to the host computer 510; receive a camera control program corresponding to the first-model battery product sent by the host computer 510; and control, by calling the camera control program, the addressing camera 531 to perform pre-welding addressing and photographing on the first-model battery product based on the second coordinate set and according to visual parameters corresponding to the first-model battery product, to obtain the fourth coordinate set. The host computer 510 is further configured to obtain at least one set of visual parameters, each set of visual parameters being used to perform pre-welding addressing and photographing on a terminal post in a battery product of a model; for each model, based on a set of visual parameters corresponding to the battery product of the model, generate and store a camera control program corresponding to the battery product of the model; and send the camera control program corresponding to the first-model battery product to the controller 520 in response to the request instruction.

It should be pointed out here that the above description of the various embodiments tends to emphasize the differences between the various embodiments, and the same or similar aspects thereof may be referenced to each other.

It should be understood that references throughout the specification to "one embodiment" or "an embodiment" imply that specific features, structures, or characteristics related to the embodiment are included in at least one embodiment of the present invention. Thus, "in one embodiment" or "in an embodiment" that appears throughout the specification may not necessarily refer to the same embodiment. In addition, these specific features, structures, or characteristics may be combined in one or more embodiments in any suitable manner. It should be understood that in the various embodiments of the present invention, the size of the serial numbers of the above steps/processes does not imply the order of execution, and the execution order of each step/process should be determined by its function and internal logic, and should not constitute any limitations on the implementation process of the embodiment of the present invention. The above serial numbers of the embodiments of the present invention are only for description and do not represent the advantages and disadvantages of the embodiments.

It should be further noted that, herein, the term "include", "comprise" or other variations thereof are intended to cover non-exclusive including, so that a process, method, article, or apparatus including a series of elements not only includes the elements, but also includes other elements not clearly listed, or further includes inherent elements of the process, method, article, or apparatus. Without more limitations, elements defined by a statement "including one" do not exclude the existence of other identical elements in the process, method, item, or apparatus that includes the elements.

In several embodiments provided in the present invention, it should be understood that the disclosed system and method may be implemented in other ways. The device embodiment described in the foregoing is merely schematic, for example, the division of units is merely division of logic functions, and in fact, there may be other division manners during implementation, for example, multiple units or components may be combined or may be integrated into another system, or some features may be omitted or not be executed. In addition, the coupling, direct coupling, or communication connection between the various components displayed or discussed can be indirect coupling or communication connection through some interfaces, equipment or units, which can be electrical, mechanical, or other forms.

The units mentioned above as separate components may be, or may not be physically separated, and the parts displayed as units may be, or may not be physical units; they may be located in one place or distributed onto a plurality of network units; and some or all of the units can be selected according to actual needs to achieve the purpose of the solution of this embodiment. In addition, all functional units in the embodiments of the present invention may be integrated into one processing unit, or each unit may serve as a separate unit, or two or more units may be integrated into one unit. The integrated units mentioned above may be implemented in a hardware form or in a form of hardware and software functional units.

The above is only an implementation of the present invention, but the scope of protection of the present invention is not limited to this. Any changes or replacements that can be easily thought of by technical personnel familiar with the technical field within the technical scope disclosed in the present invention needs to be covered within the scope of protection of the present invention.

### Industrial applicability

The embodiments of the present invention provide at least a method for determining coordinates of a terminal post, a welding method, and a welding system, which is capable of efficiently and accurately determining coordinates of a terminal post of a battery product in an addressing station coordinate system, thereby greatly reducing input of commissioning personnel, improving commissioning efficiency, and reducing a commissioning error rate, thereby being capable of improving efficiency and accuracy of pre-welding addressing and photographing, and improving production efficiency and production quality of battery products.

## Claims

1. A method for determining coordinates of a terminal post, comprising:
obtaining a first design drawing of a first-model battery product to be welded in a drawing coordinate system;
parsing the first design drawing to obtain a first coordinate set of at least one terminal post in the first-model battery product in the drawing coordinate system; and
mapping the first coordinate set to an addressing station coordinate system to obtain a second coordinate set of the at least one terminal post in the addressing station coordinate system.

2. The method for determining coordinates according to claim 1, wherein the addressing station coordinate system is obtained by translating an origin of the drawing coordinate system to a preset reference point; and
the mapping the first coordinate set to an addressing station coordinate system to obtain a second coordinate set of the at least one terminal post in the addressing station coordinate system comprises:
obtaining reference coordinates of the reference point in the drawing coordinate system; and
for each terminal post, based on the first coordinates of the terminal post and the reference coordinates, determining first offset coordinates of the terminal post relative to the reference point, and determining the first offset coordinates as second coordinates of the terminal post in the addressing station coordinate system.

3. The method for determining coordinates according to claim 2, wherein the drawing coordinate system comprises a first positioning axis and a second positioning axis that intersect each other, and positions of the first positioning axis and the second positioning axis in the drawing coordinate system are respectively aligned with positions of a third positioning axis and a fourth positioning axis in an addressing station in the addressing station coordinate system.

4. The method for determining coordinates according to claim 2 or 3, wherein the reference point comprises a preset terminal post in a preset-model battery product; and
the obtaining reference coordinates of the reference point in the drawing coordinate system comprises:
obtaining a second design drawing of the preset-model battery product in the drawing coordinate system; and
parsing the second design drawing to obtain third coordinates of the preset terminal post in the drawing coordinate system, and using the third coordinates as the reference coordinates.

5. The method for determining coordinates according to any one of claims 1 to 4, wherein the parsing the first design drawing to obtain a first coordinate set of at least one terminal post in the first-model battery product in the drawing coordinate system comprises:
extracting at least one primitive object from the first design drawing;
for each primitive object, when the primitive object is of a circular type, determining that the primitive object represents a terminal post in the first-model battery product, and determining center coordinates of the primitive object as the first coordinates of the terminal post in the drawing coordinate system; and
determining the first coordinate set based on the first coordinates of the at least one terminal post in the first-model battery product in the drawing coordinate system.

6. The method for determining coordinates according to any one of claims 1 to 5, further comprising:
sending the second coordinate set of the at least one terminal post in the addressing station coordinate system to a controller, so that the controller controls an addressing camera to perform pre-welding addressing and photographing on the terminal post in the first-model battery product based on the second coordinate set.

7. The method for determining coordinates according to any one of claims 1 to 6, further comprising:
obtaining at least one set of visual parameters, each set of visual parameters being used to perform pre-welding addressing and photographing on a terminal post in a battery product of a model; and
for each model, based on a set of visual parameters corresponding to the battery product of the model, generating and storing a camera control program corresponding to the battery product of the model, the camera control program being used to control the addressing camera to perform pre-welding addressing and photographing according to the visual parameters.

8. The method for determining coordinates according to claim 7, further comprising:
receiving a request instruction sent by the controller, the request instruction being used to request the camera control program corresponding to the first-model battery product; and
sending the camera control program corresponding to the first-model battery product to the controller.

9. A method for determining coordinates of a terminal post, comprising:
displaying a first interface by a human machine interface;
obtaining, by the human machine interface, an imported first design drawing of a first-model battery product in a drawing coordinate system in response to a drawing import operation performed on the first interface;
parsing, by a host computer, the first design drawing to obtain a first coordinate set of at least one terminal post in the first-model battery product in the drawing coordinate system;
mapping, by the host computer, the first coordinate set to an addressing station coordinate system to obtain a second coordinate set of the at least one terminal post in the addressing station coordinate system; and
displaying the second coordinate set by the human machine interface.

10. A welding method, comprising:
obtaining, by a host computer, a first design drawing of a first-model battery product to be welded in a drawing coordinate system;
parsing, by the host computer, the first design drawing to obtain a first coordinate set of at least one terminal post in the first-model battery product in the drawing coordinate system;
mapping, by the host computer, the first coordinate set to an addressing station coordinate system to obtain a second coordinate set of the at least one terminal post in the addressing station coordinate system, and sending the second coordinate set to a controller;
receiving the second coordinate set by the controller;
controlling, by the controller, an addressing camera to perform pre-welding addressing and photographing on the at least one terminal post based on the second coordinate set, to obtain a fourth coordinate set of the at least one terminal post in the addressing station coordinate system;
mapping, by the controller, the fourth coordinate set to a welding station coordinate system to obtain a fifth coordinate set of the at least one terminal post in the welding station coordinate system; and
controlling, by the controller, a welding device to perform welding on the at least one terminal post based on the fifth coordinate set, so as to electrically connect at least two battery cells in the first-model battery product through a busbar.

11. The welding method according to claim 10, further comprising:
displaying a first interface by a human machine interface;
obtaining, by the human machine interface, the imported first design drawing of the first-model battery product in the drawing coordinate system in response to a drawing import operation performed on the first interface, and sending the first design drawing to the host computer;
sending, by the host computer, the second coordinate set to the human machine interface; and
displaying the second coordinate set by the human machine interface.

12. The welding method according to claim 10 or 11, further comprising:
sending, by the controller, a request instruction to the host computer, the request instruction being used to request a camera control program corresponding to the first-model battery product; and
sending, by the host computer, the camera control program corresponding to the first-model battery product to the controller in response to the request instruction; wherein
the controlling, by the controller, an addressing camera to perform pre-welding addressing and photographing on the at least one terminal post based on the second coordinate set, to obtain a fourth coordinate set of the at least one terminal post in the addressing station coordinate system comprises:
controlling, by the controller by calling the camera control program, the addressing camera to perform pre-welding addressing and photographing on the first-model battery product based on the second coordinate set and according to visual parameters corresponding to the first-model battery product, to obtain the fourth coordinate set.

13. A welding system, comprising a host computer, a controller, an addressing device, and a welding device, the addressing device comprising an addressing camera, wherein:
the host computer is configured to obtain a first design drawing of a first-model battery product to be welded in a drawing coordinate system; parse the first design drawing to obtain a first coordinate set of at least one terminal post in the first-model battery product in the drawing coordinate system; map the first coordinate set to an addressing station coordinate system to obtain a second coordinate set of the at least one terminal post in the addressing station coordinate system; and send the second coordinate set to the controller; and
the controller is configured to receive the second coordinate set; control the addressing camera to perform pre-welding addressing and photographing on the at least one terminal post based on the second coordinate set, to obtain a fourth coordinate set of the at least one terminal post in the addressing station coordinate system; map the fourth coordinate set to a welding station coordinate system, to obtain a fifth coordinate set of the at least one terminal post in the welding station coordinate system; and control the welding device to perform welding on the at least one terminal post based on the fifth coordinate set, so as to electrically connect at least two battery cells in the first-model battery product through a busbar.

14. The welding system according to claim 13, wherein the controller comprises a first controller and a second controller;
the first controller is configured to receive the second coordinate set; control the addressing camera to perform pre-welding addressing and photographing on the at least one terminal post based on the second coordinate set to obtain the fourth coordinate set; and send the fourth coordinate set to the second controller; and
the second controller is configured to map the fourth coordinate set to the welding station coordinate system to obtain the fifth coordinate set; and control the welding device to perform welding on the at least one terminal post based on the fifth coordinate set.

15. The welding system according to claim 13 or 14, wherein the welding system further comprises a human machine interface;
the human machine interface is configured to display a first interface; obtain the imported first design drawing in response to a drawing import operation performed on the first interface; and receive and display the second coordinate set sent by the host computer; and
the host computer is further configured to obtain the first design drawing from the human machine interface; and send the second coordinate set to the human machine interface.

16. The welding system according to any one of claims 13 to 15, wherein
the controller is further configured to send a request instruction to the host computer; receive a camera control program corresponding to the first-model battery product sent by the host computer; control, by calling the camera control program, the addressing camera to perform pre-welding addressing and photographing on the first-model battery product based on the second coordinate set and according to visual parameters corresponding to the first-model battery product, to obtain the fourth coordinate set; and
the host computer is further configured to obtain at least one set of visual parameters, each set of visual parameters being used to perform pre-welding addressing and photographing on a terminal post in a battery product of a model; and for each model, based on a set of visual parameters corresponding to the battery product of the model, generate and store a camera control program corresponding to the battery product of the model; and send the camera control program corresponding to the first-model battery product to the controller in response to the request instruction.
